Europäisches Patentamt

(19) European Patent Office

Office européen des brevets

(11) Numéro de publication: **0 004 219**
**B1**

(12) **FASCICULE DE BREVET EUROPEEN**

(45) Date de publication du fascicule de brevet: **25.11.81**

(21) Numéro de dépôt: **79400111.5**

(22) Date de dépôt: **23.02.79**

(51) Int. Cl.³: **H 01 L 29/20, H 01 L 21/90**

(54) **Circuit intégré comportant un système d'interconnexion à deux nappes de conducteurs; procédé de fabrication d'un tel circuit.**

(30) Priorité: **08.03.78 FR 7806673**

(43) Date de publication de la demande:
**19.09.79 Bulletin 79/19**

(45) Mention de la délivrance du brevet:
**25.11.81 Bulletin 81/47**

(84) Etats Contractants Désignés:
**DE GB IT NL**

(56) Documents cités:
**IEEE JOURNAL OF SOLID STATE CIRCUITS, vol. SC—12, n° 5, octobre 1977, New York
R. L. VAN TUYL et al., "GaAs MESFET Logic with 4—GH$_z$ Clock Rate", pages 485—496.
IEEE SPECTRUM, vol. 14, n° 3, mars 1977, New York
R. VAN TUYL et al., "Gallium arsenide spawns speed", pages 41—47.**

(73) Titulaire: **THOMSON-CSF
173, Boulevard Haussmann
F-75360 Paris Cedex 08 (FR)**

(72) Inventeur: **Nuzillat, Gérard
"Thomson-CSF"-SCPI 173, bld Haussmann
F-75360 Paris Cedex 08 (FR)**
Inventeur: **Arnodo, Christian
"Thomson-CSF"-SCPI 173, bld Haussmann
F-75360 Paris Cedex 08 (FR)**

(74) Mandataire: **Giraud, Pierre et al,
"THOMSON-CSF" - SCPI 173, bld Haussmann
F-75360 Paris Cedex 08 (FR)**

Courier Press, Leamington Spa, England.

# Circuit intégré comportant un système d'interconnexion à deux nappes de conducteurs; procédé de fabrication d'un tel circuit

L'invention a pour objet un circuit intégré sur substrat semiconducteur et son procédé de fabrication.

On sait que depuis quelques années on utilise de tels semiconducteurs constitués par des composés des groupes III—V de la classification de Mendeleev et en particulier l'arséniure de gallium.

On sait en outre, notamment par un article de Rory L. Van TUYL et al (Journal of Solid-State Circuits I.E.E.E, vol SC12, N° 5, October 1977) que des circuits intégrés de plus en plus complexes sont réalisés sur des surfaces de plus en plus petites à l'aide d'éléments intégrés sur l'arséniure de gallium semi-isolant. Ils comportent chacun un système d'interconnexion à deux nappes de conducteurs, la nappe inférieure étant en contact électrique avec des contacts ohmiques ou Schottky sur la zone active du circuit intégré, la nappe supérieure étant séparée de la nappe inférieure par une couche de diélectrique. En outre la nappe supérieure communique avec la nappe inférieure par des ouvertures dans la couche diélectrique, au droit des conducteurs de la nappe inférieure.

Les principales difficultés rencontrées dans la fabrication de tels circuits sont la réalisation des contacts ohmiques ou Schottky de faibles dimensions et de formes parfaitement définies. Une autre difficulté rencontrée est le fait qu'une nappe de conducteurs en contact direct avec le Ga As semi-isolant risque de donner naissance à une junction et d'être la cause de phénomènes d'interface gênants.

La présente invention a pour objet un circuit intégré exempt de ces inconvénients.

Le circuit intégré selon l'invention est du type comportant des éléments intégrés sur un substrat semi-isolant monocristallin constitué par un composé d'éléments des groupes III et V de la classification de Mendeleev, les éléments actifs du circuit mettant en oeuvre, dans une zone active, une couche dopée de type n déposée sur le substrat, le circuit comportant en outre un système d'interconnexion à deux nappes de conducteurs, la nappe inférieure étant en contact électrique avec des contacts ohmiques ou Schottky sur la zone active, la nappe supérieure étant séparée de la nappe inférieure par une couche diélectrique, et la nappe supérieure communiquant avec la nappe inférieure par des ouvertures dans la couche diélectrique, au droit des conducteurs de la nappe inférieure.

Il est caractérisé en ce que, en dehors des contacts ohmiques ou Schottky, les conducteurs formant la nappe inférieure sont séparés du substrat par une mince couche diélectrique.

L'invention sera mieux comprise au moyen de la description ci-après en se référant aux dessins annexés parmi lesquels:

les figures 1 et 2 représentent respectivement vu en coupe longitudinale et en perspective arrachée, un exemple de réalisation de l'invention;

les figures 3, 4 et 5 sont des figures expliquant le procédé dit du "lift-off";

les figures 6 à 12 représentent en coupe transversale le circuit des figures 1 et 2 au cours des diverses étapes de sa fabrication.

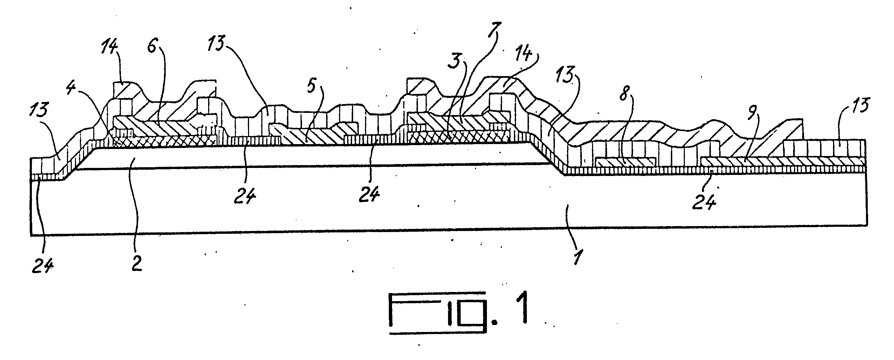

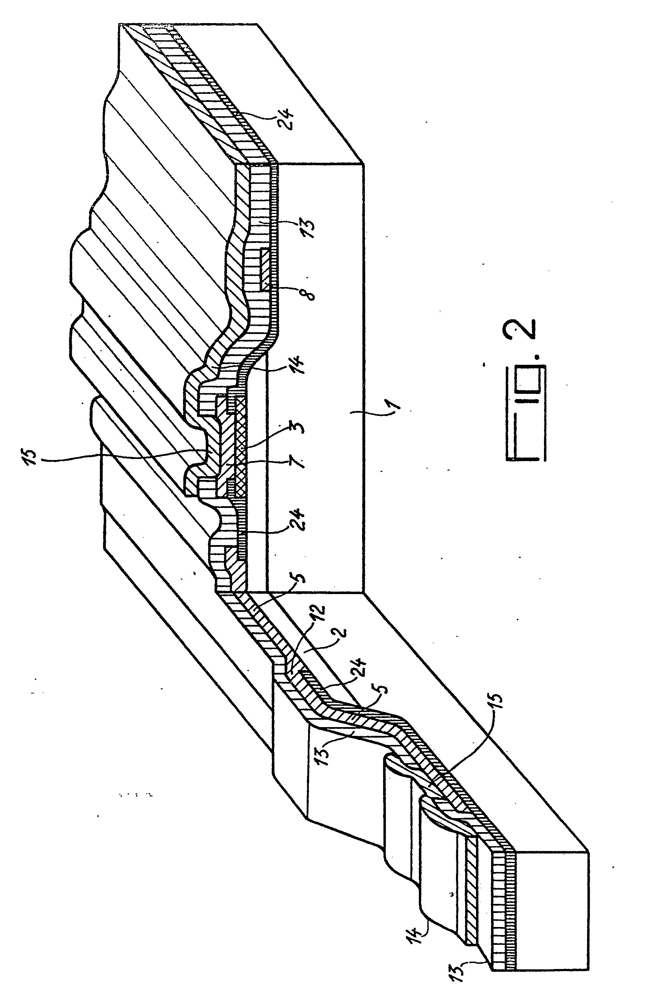

Sur les figures 1 et 2 où les mêmes références désignent les mêmes organes, on a déposé sur un substrat 1 d'arséniure de gallium Ga As une couche 2 de type n. Sur cette couche est intégré un transistor à effet de champ à grille Schottky connu sous l'appellation MESFET dans la littérature anglo-saxonne.

Ce transistor comporte une source 3 et un drain 4 constitués par des contacts ohmiques. Ces contacts peuvent être formés d'une couche d'alliage ou d'une triple couche: Nickel/(alliage Or-Germanium)/Or (épaisseurs respectives 50/900/900 Angströms). Ces deux contacts parfaitement localisés et de dimensions transversales de l'ordre de 10 $\mu$m, sont partiellement, recouverts sur leur périphérie par une couche 24 d'épaisseur de l'ordre de 1 000 Angströms, par exemple de silice Si $O_2$ ou de nitrure de silicium Si$_3$ N$_4$.

Selon l'invention, celle-ci recouvre l'ensemble du système comme représenté figure 2, tout en comportant des ouvertures ponctuelles débouchant sur la couche 2. Un contact Schottky 5 servant de grille de commande est formé dans une de ces ouvertures, située entre la source et le drain. Il a la forme illustrée et recouvre sur ses bords la couche 24. Sa dimension longitudinale est de l'ordre de 0,5 à 1 $\mu$m et son épaisseur d'environ 0,3 $\mu$m. Ce contact Schottky peut être réalisé sous la forme d'un dépôt multicouche de Ti/Pt/Au/Ti d'épaisseurs respectives 500, 500, 1 500, 50 Angströms. La couche de Ti de 50 Angströms permet l'adhérence du diélectrique 13 destiné à la recouvrir. Ce contact Schottky 5 constitue avec les dépôts de même nature 6, 7, 8 et 9, les éléments d'une première nappe d'interconnexion. On remarque que les éléments 8 et 9 sont situés en dehors de la couche active et sont déposés sur la couche 24, ceci conformément à l'invention. Une autre couche 13 de diélectrique beaucoup plus épaisse que la couche 24 recouvre l'ensemble. Elle présente des ouvertures aux emplacements des contacts de source et de drain 6 et 7. La figure 2 montre comment la grille Schottky 5 reste en contact direct avec la zone active 2 puis passe en un point 12 au dessus de la couche 24 pour se mettre au niveau de la nappe inférieure de connexion.

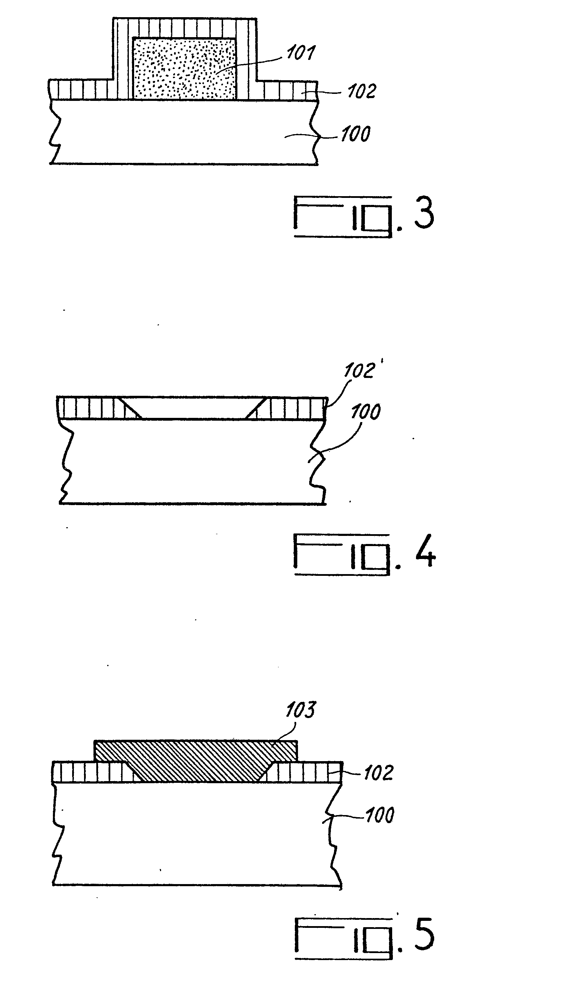

La couche 13 de silice ou de nitrure de silicium beaucoup plus épaisse que la couche inférieure (rapport de l'ordre de 5 à 1) a, en plus des ouvertures au droit de la source et du drain, une ouverture au droit de l'élément de connexion 9 de la nappe inférieure. Dans ces ouvertures et au dessus de cette couche est placée une nappe supérieure d'interconnexion 14. Cette nappe supérieure doit adhérer au diélectrique. C'est par exemple un dépôt multicouche Ti/Pt/Au ou Cr/Pt/Au. Cette nappe supérieure est convenablement isolée de la nappe inférieure par la couche épaisse de diélectrique 13. Cette couche épaisse de diélectrique a également pour avantage de passiver convenablement la grille Schottky. En 15, un trou permet la connexion entre les deux nappes d'interconnexions. Pour réaliser cet ensemble, plusieurs étapes sont nécessaires. Plusieurs d'entre elles, conformément à l'invention sont réalisées selon la technique connue dans la littérature anglo-saxonne sous le vocable "lift-off". Ce procédé est rappelé à l'aide des figures 3, 4 et 5.

Sur la figure 3, on voit un substrat 100 que l'on a recouvert d'une couche de résine 101. Celle-ci a été insolée à travers un masque, de façon à ce qu'elle ne subsiste après attaque que dans une zone 101 où elle forme un pion.

L'ensemble a été ensuite recouvert d'une couche de diélectrique 102 qui recouvre totalement le pion 101.

Si l'on attaque la structure de la figure 3 par un agent chimique capable de dissoudre le pion 101, ce dernier disparaît et entraîne la résine qui le coiffe. C'est le "lift-off".

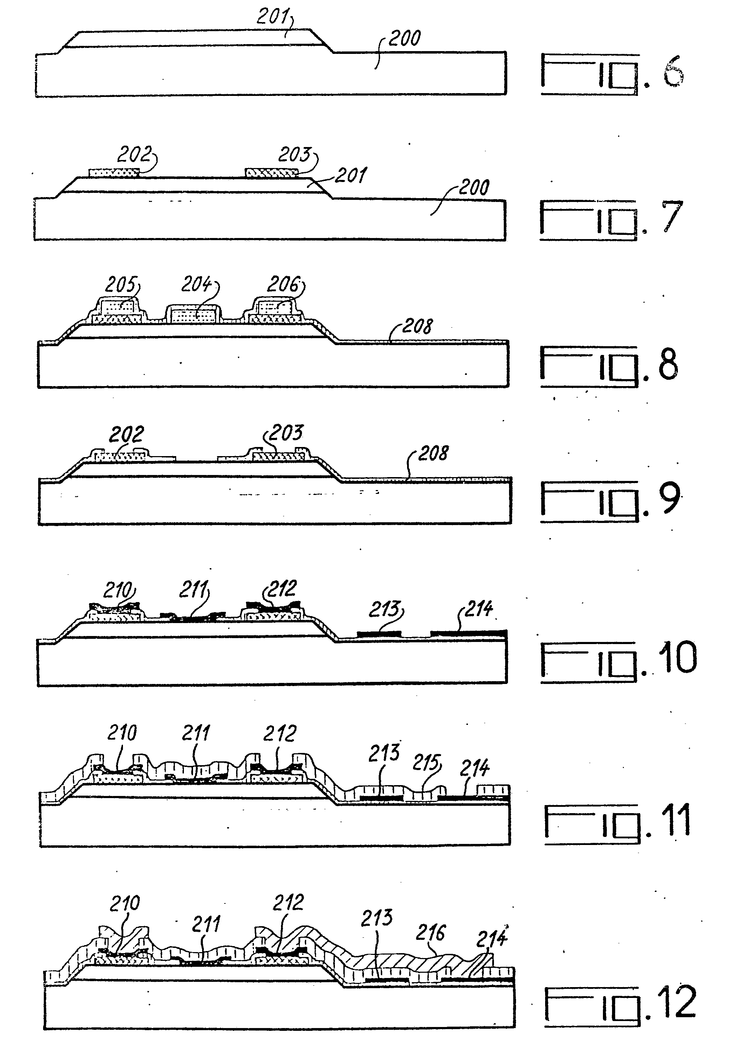

Il subsiste alors sur le substrat une aire dénudée parfaitement définie, ainsi que le montre la figure 4.

Sur la figure 5, on voit que cette aire dénudée est recouverte par un dépôt de métal 103, dont la zone de contact avec le substrat 100 pourra être délimitée avec une grande précision. Cette technique permet la formation de contacts ayant des dimensions de l'ordre de 0, 5 $\mu$m, avec une précision beaucoup plus grande que les autres méthodes.

Les étapes du procédé de fabrication selon l'invention sont représentées pour un échantillon en coupe transversale par les illustrations des figures 6 à 12.

On voit sur la figure 6 que sur le substrat 200 d'arséniure de gallium semi-isolant a été déposé, par épitaxie une couche de Ga As 201, de type n dont l'épaisseur est inférieure à un micron. Cette couche a subi une attaque de type "mésa" et c'est sur celle-ci que l'on va former un élément actif de type MESFET, c'est à dire un transistor à effet de champ à grille Schottky. Cet élément sera isolé d'autres éléments similaires par le substrat lui-même. Il est bien entendu que l'on peut faire simultanément plusieurs éléments, ceux-ci étant reliés entre eux par les nappes d'interconnexion dont on va décrire les étapes de fabrication.

Figure 7, par masquage "lift-off", et évaporation sous vide, ou tout autre procédé, deux contacts ohmiques 202 et 203 ont élé déposés.

L'opération se fait comme indiqué figures 3 à 5. Ces contacts sont constitués par trois couches superposées, respectivement, comme on l'a vu plus haut, faites de nickel, d'alliage Au-Ge et d'or.

Sur la figure 8, on voit que trois pions de résine 204, 205 et 206, sont déposés respectivement sur les contacts 202 et 203 et aussi à l'emplacement où doit se former ultérieurement la grille Schottky du transistor. Ensuite la couche 208, de silice par exemple, est déposée en faible épaisseur sur l'ensemble.

Cette couche diélectrique 208 a une faible épaisseur de 1000 à 1500 Angströms. Elle peut être déposée par pulvérisation cathodique à la température ambiante. D'autre procédés peuvent être utilisés mais ils ne doivent pas altérer la résine 204, 205 et 206.

Figure 9, par "lift-off" la résine a été enlevée, laissant à nu le substrat à l'emplacement du pion 204. Les pions 205 et 206 laissent la place à des ouvertures qui livrent accès aux contacts ohmiques 202 et 203. La couche 208 subsiste au niveau du substrat.

Figure 10, à travers un nouveäu masque la nappe inférieure d'interconnexion est déposée. Elle est faite par un quadruple dépôt de titane, platine, or, titane. En 211, elle forme le contact Schottky et en 210 et 212 elle assure les connexions à la source et au drain. Le "lift-off" assure une très grande reproductibilité des différents motifs grâce à la géométrie parfaitement définie de l'ouverture. En 213 et 214 la nappe inférieure assure les connexions avec diverses portions de circuits non représentées.

Il est à remarquer que la technique du "lift-off" assure une grande précision de la délimitation géométrique du contact Schottky. On voit que les connexions 213 et 214 sont isolées du substrat. Il n'y a donc plus de phénomènes d'interface entre le dépôt conducteur de la nappe et le Ga As semi-isolant, phénomènes qui comme la demanderesse l'a découvert, perturbent le fonctionnement de tels circuits. Il est à souligner que grâce à cette technique toute intéraction entre les électrodes est évitée.

Figure 11, toujours par le même technique de pulvérisation cathodique et par "lift-off", on a formé sur l'ensemble une seconde couche diélectrique 215, de silice, beaucoup plus épaisse, de l'ordre du micron ou davantage. Cette couche protège efficacement la grille Schottky qu'elle recouvre en totalité, voir figures 1 et 2.

Elle est ouverte par "lift-off" figure 12 de façon à ménager un accès à la source et au drain et à ménager un autre accès avec le conducteur 214 de la nappe inférieure de connexion. La nappe supérieure de connexion 216 en titane-platine-or est alors déposée comme le montre la figure 12. Elle permet les prises de contacts sur la source et le drain. On constate que la grille Schottky est déjà protégée, et que les contacts ohmiques et leurs résistances d'accès sont facilement reproductibles. Enfin, aux points de croisement sans interconnexion, les nappes de conducteurs sont séparées par une couche épaisse de diélectrique. On constate encore qu'aucun conducteur, en dehors des zones actives, n'est en contact direct avec le substrat. On remarque aussi que les croisements avec interconnexions se font en dehors de la zone active. On remarque également que l'opération d'alliage qui forme les contacts ohmiques peut indifféremment être réalisée au stade des figures 7 ou 9. Il peut être plus avantageux pour la définition géométrique de ces contacts ohmiques de faire cette opération au stade de la figure 9.

Un autre avantage de l'invention réside dans le fait que les grilles Schottky des transistors à effet de champ peuvent être très étroites, comme c'est souhaitable, tout en présentant une grande surface de contact grâce au débordement du métal sur la première couche de diélectrique.

## Revendications

1. Circuit intégré du type comportant des éléments intégrés sur un substrat semi-isolant monocristallin (1) constitué par un composé d'éléments des groupes III et V de la classification de Mendeleev, les éléments actifs du circuit mettant en oeuvre, dans une zone active une couche (2) dopée de type n déposée sur le substrat (1), le circuit comportant en outre un système d'interconnexion à deux nappes de conducteurs, la nappe inférieure étant en contact électrique avec des contacts ohmiques (3, 4) ou Schottky (5) sur la zone active, la nappe supérieure étant séparée de la nappe inférieure par une couche diélectrique (13), et la nappe supérieure communiquant avec la nappe inférieure par des ouvertures dans la couche diélectrique (13), au droit des conducteurs de la nappe inférieure, le circuit intégré étant caractérisé en ce que, en dehors des contacts ohmiques ou Schottky, les conducteurs (8, 9) formant la nappe inférieure sont séparés du substrat par une mince couche diélectrique (24).

2. Circuit suivant la revendication 1, caractérisé en ce que le composé est l'arséniure de gallium Ga As.

3. Circuit suivant la revendication 2, caractérisé en ce que les couches diélectriques sont faites de silicium ou de nitrure de silicium.

4. Circuit suivant la revendication 2, caractérisé en ce que les contacts ohmiques sont faits de trois couches superposées respectivement de nickel, d'alliage or-nickel et d'or.

5. Circuit suivant la revendication 2, caractérisé en ce que les contacts Schottky sont faits de couches superposées respectivement de titane, platine, or et titane.

6. Circuit suivant la revendication 5, caractérisé en ce que la nappe inférieure est faite du même matériau que les contacts Schottky.

7. Procédé de fabrication de circuits intégrés selon la revendication 1 sur un substrat semi-isolant (1) constitué par un composé monocristallin des groupes III et V de la classification du Mendeleev, comportant l'étape de formation d'une couche (2) de type n du même composé, et de traitement de cette couche pour isoler les zones actives et le dépôt des contacts ohmiques sur ces zones actives, caractérisé par les étapes suivantes:

a) dépôt des contacts ohmiques (3, 4) sur la zone active;

b) dépôt sur les contacts ohmiques (3, 4) et sur les zones ou se formeront les contacts Schottky (5) de résine photosensible;

c) dépôt sur l'ensemble d'une première couche de diélectrique dont l'épaisseur est de 1000 à 1300 angström;

d) dissolution de la résine;

e) ouverture par "lift-off" de la première couche mince de diélectrique, ceci entrainant la mise à nu de la zone active;

f) dépôt dans ces ouvertures sur les contacts ohmiques et sur le première couche diélectrique d'une première nappe de connexion en particulier, formant les contacts Schottky (5);

g) dépôt sur l'ensemble de pions (101) de résine aux emplacements des contacts à établir;

h) dépôt sur l'ensemble d'une deuxième couche de diélectrique et ouverture par "lift-off" de cette couche à des emplacements, laissant à nu la première nappe de connexion;

i) dépôt sur cette deuxième couche de diélectrique et dans ses ouvertures, de la deuxième nappe de connexion.

8. Procédé suivant la revendication 7, caractérisé en ce que le composé est l'arséniure de gallium.

9. Procédé suivant la revendication 8, caractérisé en ce que le diélectrique est la silice $SiO_2$ ou du nitrure de silicium $Si_3N_4$.

## Claims

1. An integrated circuit comprising integral elements on a semi-insulating, monocrystalline substrate (1) formed by a compound of substances of the Groups III and V of the classification Mendeleev, with the active elements of the circuit effecting in an active area a doped coating of the n-type applied onto the substrate (1), and with the circuit comprising in addition an interconnecting system of two conductor sheets, the lower sheet being in electrical contact with the ohmic (3, 4) or Schottky (5) contacts on the active area, the upper sheet being separated from the lower sheet by a dielectric coating (13) and the upper sheet communicating with the lower sheet by apertures in the dielectric coating opposite the conductors of the lower sheet, said integrated circuit being characterized in that at the outside of the ohmic or Schottky contacts, the conductors (8, 9) which form the lower sheet, are separated from the substrate by a thin dielectric coating (24).

2. Circuit according to claim 1, characterized in that the compound is gallium arsenide Ga As.

3. Circuit according to claim 1, characterized in that the dielectric coatings are made of silicon or silicon nitride.

4. Circuit according to claim 2, characterized in that the ohmic contacts are made of three superimposed coatings of nickel, gold-nickel alloy and gold.

5. Circuit according to claim 2, characterized in that the Schottky contacts are made of superimposed layers of titanium, platinum, gold and titanium, respectively.

6. Circuit according to claim 5, characterized in that the lower sheet is made of the same material as the Schottky contacts.

7. Method of making integrated circuits according to claim 1 on a semi-insulation substrate (1) formed by a monocrystalline compound of the Groups III and V of the Mendeleev classification, comprising the steps of forming a coating (2) of the type n of the same compound and treating said coating to insulate the active areas and depositing of ohmic contacts on the active areas, characterized by the following steps:

a) depositing of ohmic contacts (3, 4) on the active area,

b) depositing photosensitive resin on the ohmic contacts (3, 4) and on the areas where the Schottky contacts are formed,

c) depositing on the unit a first dielectric coating, the thickness of which is 1000 to 1300 angström,

d) dissolution of the resin,

e) laying open by lift-off the first thin dielectric coating which causes exposure of the active area,

f) depositing in the apertures of the ohmic contacts and on the first dielectric coating a first connection sheet, whereby the Schottky contacts (5) are formed,

g) depositing resin pions (101) on the unit at the emplacements where the contacts are to be established,

h) depositing on the unit a second dielectric coating and opening said coating by lift-off at said emplacements, leaving the first connecting sheet exposed,

i) depositing the second connecting sheet on said second dielectric coating and in the apertures thereof.

8. Method according to claim 7, characterized in that the compound is gallium arsenide.

9. Method according to claim 8, characterized in that the dielectric substance is silica $SiO_2$ or silicium nitride $Si_3N_4$.

**Patentansprüche**

1. Integrierte Schaltung, die integrierte Elemente auf einem half-isolierenden, Monokristall-Substrat (1) einschliesst, das aus einer Verbindung der Gruppen III und V der Klassifikation von Mendeleev geformt ist, wobei die aktiven Elemente der Schaltung in einer aktiven Zone eine getränkte Schicht (2) von n-Typ bilden und die Schaltung darüber hinaus ein Verbindungssystem von zwei leitenden Flächen enthält, in dem die untere Fläche in elektrischer Verbindung mit den Ohmschen Kontakten (3, 4) oder Schottky-Kontakten (5) in der aktiven Zone steht, und die obere Fläche von der unteren Fläche durch eine dielektrische Schicht (13) getrennt ist, und wobei die obere Fläche mit der unteren durch Öffnungen in der dielektrischen Schicht (13), gegenüber den Leitern der unteren Fläche, in Verbindung steht, dadurch gekennzeichnet, dass ausserhalb der Ohmschen oder Schottky Kontakte die Leiter (8, 9), welche die untere Fläche bilden, vom Substrat durch eine dünne dielektrische Schicht getrennt sind.

2. Schaltung gemäss Anspruch 1, dadurch gekennzeichnet, dass die Verbindung Gallium Arsenmetall Ga As ist.

3. Schaltung gemäss Anspruch 2, dadurch gekennzeichnet, dass die dielektrischen Schichten aus Silicium oder Silicium Nitrid bestehen.

4. Schaltung gemäss Anspruch 2, dadurch gekennzeichnet, dass die Ohmschen Kontakte aus drie übereinanderliegenden Schichten aus Nickel, einer Legierung aus Gold und Nickel bzw. Gold bestehen.

5. Schaltung gemäss Anspruch 2, dadurch gekennzeichnet, dass die Schottky-Kontakte aus übereinanderliegenden Schichten von Titan, Platin bzw. Gold und Platin bestehen.

6. Schaltung gemäss Anspruch 5, dadurch gekennzeichnet, dass die untere Fläche aus dem gleichen Material besteht wie die Schottky-Kontakte.

7. Verfahren zur Herstellung von integrierten Schaltungen gemäss Anspruch 1 auf einem halb-isolierend Substrat (1), bestehend aus einer monokristallinen Verbindung der Gruppen III und V der Klassifikation von Mendeleev, das den Schritt der Bildung einer Schicht (2) vom n-Typ aus der gleichen Verbindung einschliesst sowie die Behandlung dieser Schicht zwecks Isolierung der aktiven Zonen und Auflegen von Ohmschen Kontakten auf die aktiven Zonen, gekennzeichnet durch die folgenden Schritte:

a) Auflegen von Ohmschen kontakten (3, 4) auf die aktive Zone,

b) Auflegen von lichtempfindlichen Harz auf die Ohmschen kontakte (3, 4) und auf die Zonen, wo die Schottky-Kontakte gebildet werden,

c) Auflegen auf die Anlage einer ersten dielektrischen Schicht, deren Dicke 1000 bis 1300 Angström beträgt,

d) Auflösen des Harzes,

e) Offenlegen durch Abheben der ersten dünnen dielektrischen Schicht, wodurch ein Freilegen der aktiven Zone erfolgt,

f) Auflegen in den Offnungen der Ohmschen Kontakte und auf der ersten dielektrischen Schicht einer ersten Verbindungsfläche wodurch die Schottky-Kontakte (5) gebildet werden,

g) Auflegen von Harzpions (101) auf der Anlage an den Stellen, wo die Kontakte gebildet werden,

h) Auflegen auf die Anlage einer zweiten dielektrischen Schicht und Offenlegen dieser Schicht durch Abheben an den genannten Stellen, wobei die erste Fläche freigelegt wird,

i) Auflegen der zweiten Verbindungsfläche auf die zweite dielektrische Schicht und in ihre Öffnungen.

8. Verfahren gemäss Anspruch 7, dadurch gekennzeichnet, dass die Verbindung Gallium Arsenmetall ist.

9. Verfahren gemäss Anspruch 8, dadurch gekennzeichnet, dass die dielektrische Substanz Kieselerde $SiO_2$ oder Silicium Nitrid $Si_3N_4$ ist.

Fig. 1

Fig. 2

Fig. 3

Fig. 4

Fig. 5

Fig. 6

Fig. 7

Fig. 8

Fig. 9

Fig. 10

Fig. 11

Fig. 12